# EUROPÄISCHE PATENTSCHRIFT

(11) **EP 2 155 926 B1**
(45) Veröffentlichungstag und Bekanntmachung des Hinweises auf die Patenterteilung: **01.09.2010**
(21) Anmeldenummer: 08760431.0
(22) Anmeldetag: 03.06.2008
(51) Int. Cl.: C23C 16/458, C23C 16/46, C30B 25/10, C30B 25/16

(54) **VORRICHTUNG ZUR TEMPERATURSTEUERUNG DER OBERFLÄCHENTEMPERATUREN VON SUBSTRATEN IN EINEM CVD-REAKTOR**
DEVICE FOR THE TEMPERATURE CONTROL OF THE SURFACE TEMPERATURES OF SUBSTRATES IN A CVD REACTOR
DISPOSITIF DE RÉGULATION DE LA TEMPÉRATURE DES SURFACES DE SUBSTRATS DANS UN RÉACTEUR CVD

(30) Priorität: 06.06.2007 DE 102007026348
(43) Veröffentlichungstag der Anmeldung: 24.02.2010
(73) Patentinhaber: AIXTRON AG, 52134 Herzogenrath (DE)
(72) Erfinder: FRANKEN, Walter, 52249 Eschweiler (DE); KÄPPELER, Johannes, 52146 Würselen (DE)
(74) Vertreter: Rieder, Hans-Joachim
(86) Internationale Anmeldenummer: PCT/EP2008/056847
(87) Internationale Veröffentlichungsnummer: WO 2008/148759

(56) Entgegenhaltungen:
- WO-A-02/38840
- US-A- 5 177 878
- US-A1- 2006 222 481
- US-A1- 2007 015 374

## Beschreibung

Die Erfindung betrifft einen CVD-Reaktor mit einer Vielzahl auf einem drehangetriebenen Suszeptor auf dynamischen Gaspolstern getragenen Drehtellern, wobei jedes Gaspolster von einem individuell gesteuerten Gasstrom gebildet wird und jeder Gasstrom abhängig von einer von einem Temperaturmessorgan gemessenen Oberflächentemperatur von einem individuellen Stellglied variierbar ist.

Die DE 100 56 029 A1 bzw. EP 1 335 997 B1 beschreiben einen derartigen CVD-Reaktor. Bei der dort beschriebenen Vorrichtung ist ein im Wesentlichen kreisscheibenförmiger Suszeptor vorgesehen, der auf seiner in einer Horizontalebene liegenden Oberfläche eine Vielzahl von Vertiefungen aufweist, in welcher jeweils ein Drehteller einliegt, auf dem ein oder mehrere Substrate gelegt werden können, die in einer Prozesskammer mit einer Schicht, insbesondere einer Halbleiterschicht, beschichtet werden können, wobei das schichtbildende Material gasförmig durch ein Gaseinlassorgan in die Prozesskammer eingeleitet wird. Die Drehteller lagern auf individuellen Gaspolstern, wobei das Gas derart in den Zwischenraum zwischen Unterseite der Drehteller und Boden der Vertiefung eingeleitet wird, dass die Drehteller drehen. Unterhalb des Suszeptors befindet sich eine Heizung, die den Suszeptor von unten aufheizt. Über Wärmeleitung und Wärmestrahlung werden dadurch die einzelnen Drehteller ebenfalls aufgeheizt. Die Oberflächentemperaturen der Drehteller bzw. die Oberflächentemperaturen der auf den Drehtellern aufliegenden Substrate werden mittels Temperaturmessorganen überwacht. Die Oberflächentemperaturen können individuell dadurch variiert werden, dass durch Erhöhung oder Verminderung des das jeweilige Gaspolster bildenden Gasstroms die Höhe des Gaspolsters variiert wird. Dadurch wird der Wärmeübertrag durch den Spalt zwischen Drehteller und Boden der Vertiefung verändert.

Das von der EP 1 335 997 B1 beschriebene Verfahren betrifft die Temperaturregelung durch Variation der Gaspolsterhöhe. Die Gasströme werden mit Gasmassen-Steuereinrichtungen eingestellt.

Die DE 10 2006 018 514 A1 beschreibt eine Vorrichtung zur Steuerung der Oberflächentemperatur eines Substrates in einer Prozesskammer. Dort wird nicht die Höhe des Gaspolsters variiert, sondern die Zusammensetzung des Gases, welches aus einer Gasmischung besteht. Eines der Gase besitzt eine hohe Wärmeleitfähigkeit. Ein anderes Gas besitzt eine geringere Wärmeleitfähigkeit.

Aus der DE 103 23 085 A1 ist eine CVD-Beschichtungsvorrichtung bekannt, bei der ein drehbar im Reaktorgehäuse angeordneter Träger eine Vielzahl von Suszeptoren trägt zur Aufnahme jeweils eines Substrates.

Aus der DE 10133 914 A1 ist eine Prozesskammer mit abschnittsweise unterschiedlich drehangetriebenem Boden bekannt. Eine gemeinsame Gaszuleitung mündet in einem Gaskanalsystem des Suszeptors. Dort findet eine Aufteilung in mehrere Lagerkammern statt, in der jeweils der Substrathalter einliegt, der von einem Gasfilm getragen wird.

Aus der DE 100 43 600 A1 ist eine Beschichtungsvorrichtung mit einem drehbar in einem Reaktorgehäuse angeordneten Träger bekannt, wobei der Träger eine Vielzahl von satellitenartig um das Drehzentrum des Trägers angeordnete Aufnahmekammern trägt, in welchen jeweils ein Substrathalter einliegt.

Die EP 0 242 898 B1 beschreibt einen Suszeptor in einem CVD-Reaktor, wobei sich die Substrate während der Beschichtung drehen.

Bei der eingangs genannten gattungsgemäßen Vorrichtung werden für jeden Drehteller eine individuelle Zuleitung von außen in das Reaktorgehäuse benötigt, da die dort von Gasmassen-Steuereinrichtungen gebildeten Stellglieder einem ortsfesten Gasmischsystem zugeordnet sind. Soll bei der gattungsgemäßen Vorrichtung zusätzlich zu den Drehtellern auch der Suszeptor um seine Achse gedreht werden, so ist eine komplizierte Gaszuleitung erforderlich, da eine Vielzahl von außerhalb des Reaktors liegenden ortsfesten Zuleitungen in mit dem Suszeptor mitdrehende Zuleitungen individuell korrespondieren muss.

Der Erfindung liegt die Aufgabe zugrunde, die gattungsgemäße Vorrichtung gebrauchsvorteilhaft zu verbessern.

Gelöst wird die Aufgabe durch die in den Ansprüchen angegebene Erfindung, wobei die Ansprüche 2 bis 12 vorteilhafte Weiterbildungen des im Anspruch 1 angegebenen CVD-Reaktors sind.

Zunächst und im Wesentlichen ist vorgesehen, dass die Stellglieder mit dem Suszeptor mitdrehen. Hierzu sind sie einem den Suszeptor tragenden Träger zugeordnet. In einer Weiterbildung der Erfindung ist vorgesehen, dass in den Träger eine gemeinsame Gaszuleitung mündet. Der Träger kann hierbei einen sich mit dem Suszeptor mitdrehenden Abschnitt und einen gegenüber dem Reaktorgehäuse ortsfesten Abschnitt aufweisen. Die gemeinsame Gaszuleitung ist dem ortsfesten Abschnitt zugeordnet. Die gemeinsame Gaszuleitung kann in ein Gasverteilvolumen münden, von welchem individuelle Zuleitungen zu jedem Stellglied abzweigen. Von jedem Stellglied geht dann jeweils eine Zuleitung ab, die den Gasstrom in eine Vertiefung befördert, in welcher jeweils ein Drehteller angeordnet ist, der jeweils auf einem von dem individuellen Gasstrom gebildeten individuellen Gaspolster aufliegt. Die Stellglieder sind vorzugsweise Ventile. Da sich die Ventile mit dem Suszeptor mitdrehen, ist eine besondere Ansteuerung letzterer erforderlich. Diese kann telemetrisch oder über Schleifkontakte erfolgen. Ist eine Stromversorgung der Stellglieder erforderlich, so kann diese induktiv oder ebenfalls über Schleifkontakte erfolgen. Bevorzugt halten die Ventile stromlos ihre Stellung. In der Zuleitung kann ein Druck-Controller angeordnet sein, um den Gasdruck in der gemeinsamen Zuleitung konstant zu halten. Das Verfahren zeichnet sich im Besonderen dadurch aus, dass die Oberflächentemperaturen mehrerer im Wesentlichen ringförmig um das Zentrum des Suszeptors angeordneter Drehteller oder Substrate von einem dem jeweiligen Ring individuell zugeordneten einzigen Temperaturmessorgan nacheinander gemessen werden. In entsprechender Weise werden die Gasströme zu den zugehörigen Gaspolstern entsprechend nacheinander varüert. Die Variation der Gaspolsterhöhe erfolgt somit in gewissen konkreten Abständen nacheinander, wobei die Zeit zwischen den Stell- bzw. Regelereignissen kurz ist in Bezug auf die relativ träge Temperaturänderung. Der Träger kann einen im Inneren des Reaktorgehäuses angeordneten Abschnitt und einen außerhalb des Reaktorgehäuses angeordneten Abschnitt aufweisen. Die Ventile sind bevorzugt dem außerhalb des Reaktorgehäuses angeordneten Abschnitt, und zwar dem drehangetriebenen Abschnitt, des Trägers zugeordnet. Der Träger kann auch einen drehfesten Abschnitt besitzen. Dieser weist die gemeinsame Zuleitung auf. In einer bevorzugten Weiterbildung ist vorgesehen, dass die Stellglieder sternförmig um die Drehachse des Trägers gruppiert sind. In entsprechender Weise sind auch die Zuleitungen sternförmig um das Zentrum, also in gleichmäßiger Winkelverteilung, angeordnet. Der Träger kann eine Hohlwelle umfassen, auf dessen Stirnrandkante der Suszeptor aufliegt. In dieser Hohlwelle kann ein Kern stecken, der die gemeinsame Gaszuleitung aufweist. Das Gasverteilvolumen kann von einer Ringkammer gebildet sein, deren Wände sowohl vom Kern als auch von der Zuleitung gebildet sind. Die Ringkammer kann sich im Lagerspalt zwischen Hohlwelle und Kern befinden. Zur Lagerung der Hohlwelle ist ein Lagergehäuse vorgesehen, welches fest mit dem Reaktorgehäuse verbunden ist. Die Hohlwelle dreht sich somit zwischen Kern und Lagergehäuse. Es sind entsprechende Lager und Dichtelemente vorgesehen, damit im Bereich der Lagerung der Hohlwelle eine Gasdichtigkeit zwischen dem Äußeren und dem Inneren des Reaktors gewährleistet ist.

Ein Ausführungsbeispiel der Erfindung wird nachfolgend anhand beigefügter Zeichnungen erläutert. Es zeigen:

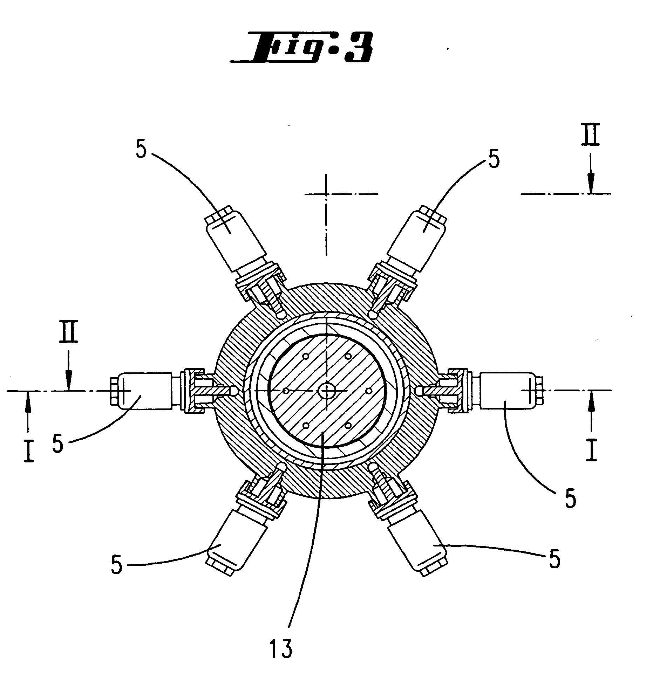

- Fig. 1: die zur Erläuterung der Erfindung wesentlichen Teile eines CVD- Reaktors im Querschnitt gemäß der Linie I - I in Fig. 3,

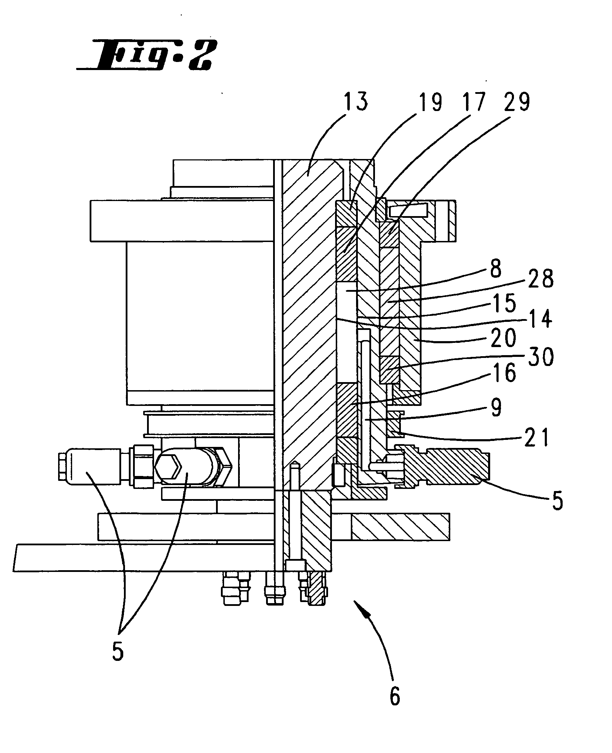

- Fig. 2: den Schnitt gemäß der Linie II - II in Fig. 3,
- Fig. 3: einen Schnitt gemäß der Linie III - III in Fig.1,
- Fig. 4: eine Draufsicht gemäß Pfeil IV auf den Suszeptor,

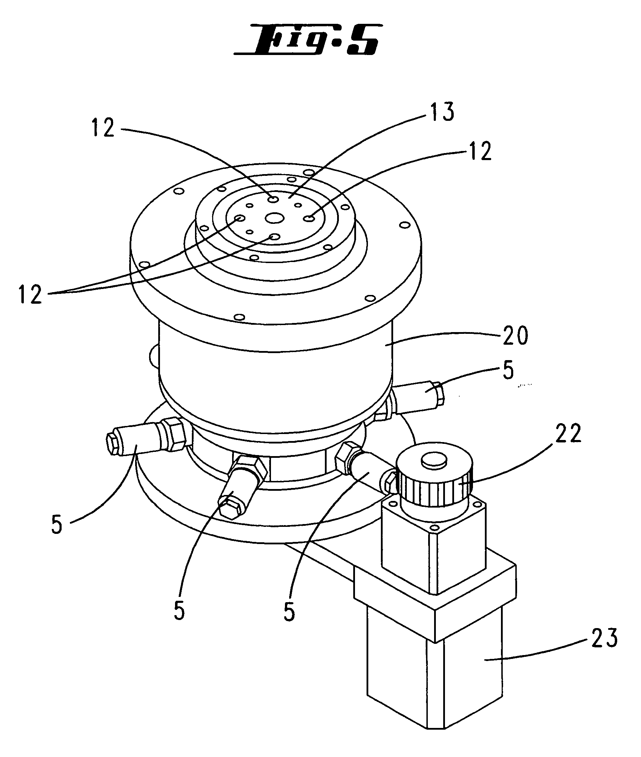

- Fig. 5: eine perspektivische Ansicht eines unteren, in einem Lagergehäuse sit- zenden Trägers nebst Antriebsmotor, und
- Fig. 6: eine schematische Darstellung des Gasflusses.

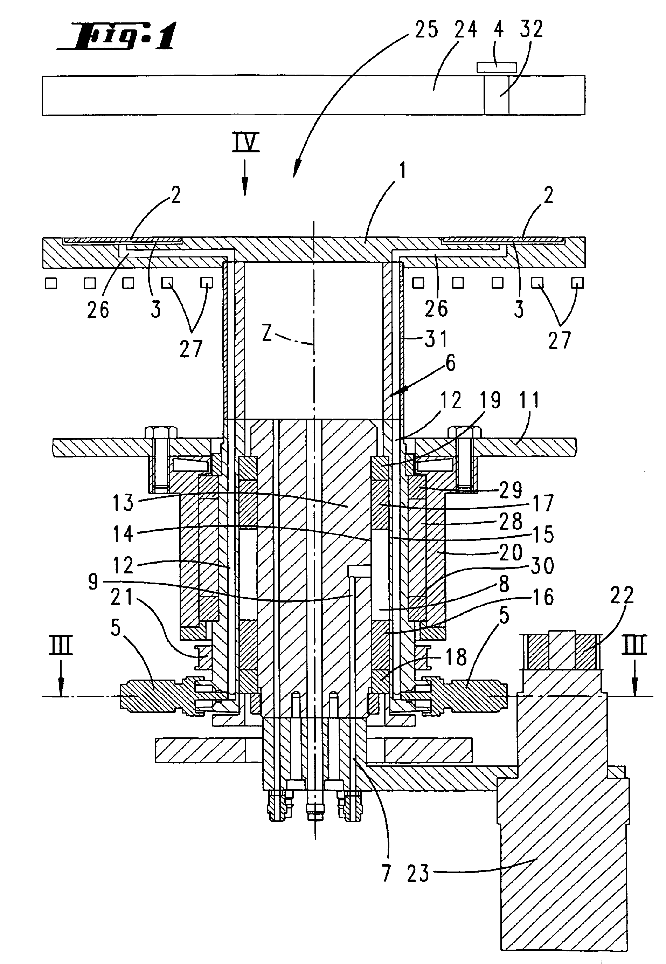

Der CVD-Reaktor besitzt ein Reaktorgehäuse, dessen untere Wandung 11 in der Fig. 1 dargestellt ist, und welches das Innere des Reaktorgehäuses gas- und druckdicht nach außen hin abkapselt. Innerhalb des Reaktorgehäuses 11 befindet sich ein Gaseinlassorgan 24, welches nicht dargestellte, in einer Horizontalebene angeordnete Gasaustrittsöffnungen aufweist, durch welche die Prozessgase in eine unterhalb des Gaseinlassorgans 24 angeordnete Prozesskammer 25 strömen kann. Der Boden der Prozesskammer 25 wird von der Oberfläche eines Suszeptors 1 ausgebildet. Der Suszeptor 1 besteht aus Graphit und kann um die Konturachse Z gedreht werden.

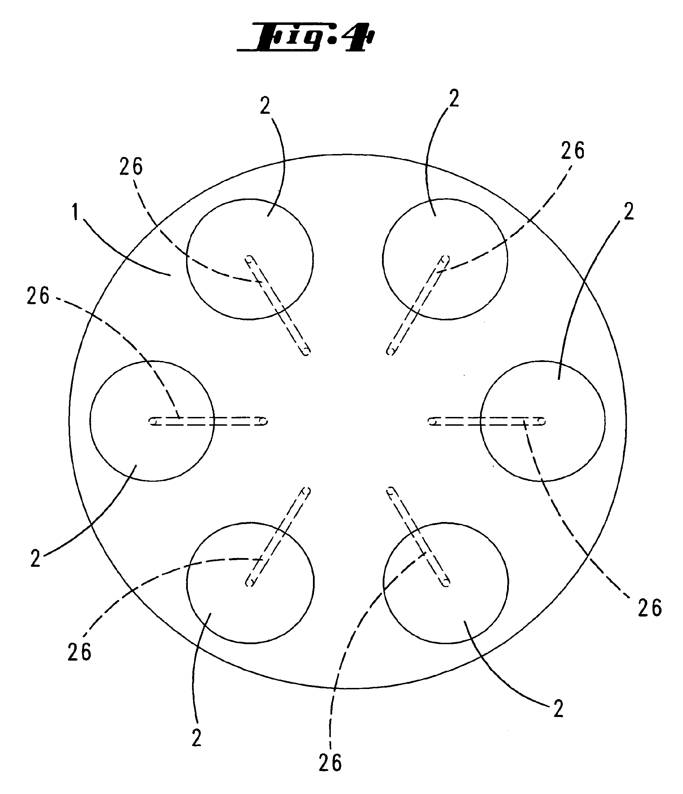

Wie der Fig. 4 und der Fig. 1 zu entnehmen ist, lagert der Suszeptor 1 eine Vielzahl von Drehtellern 2, die von kreisscheibenförmigen Graphitelementen ausgebildet sind und die in entsprechenden Ausnehmungen des Suszeptors 1 einliegen. In den Boden einer jeden Ausnehmung mündet eine individuelle Zuleitung 26, durch die jeweils ein individueller Gasstrom in den Spalt zwischen der Unterseite des Drehtellers 2 und den Boden der Ausnehmung eingebracht werden kann. Dieser Gasstrom bildet ein Gaspolster aus, auf welchem der Drehteller 2 mit einem Abstand zum Boden gelagert wird. Die Gasströme werden derart in die Ausnehmung eingebracht, dass dem jeweiligen Drehteller 2 eine Drehung aufgezwungen wird.

Oberhalb einer Öffnung 32 im Gaseinlassorgan 24 befindet sich ein Temperatursensor 4, beispielsweise ein Pyrometer. Der Temperatursensor 4 befindet sich unmittelbar oberhalb der Drehteller 2 und auf entsprechendem Radialabstand zum Drehzentrum Z, so dass mit dem Temperatursensor 4 die Oberflächentemperatur des Drehtellers 2 bzw. die Oberflächentemperatur eines oder mehrerer auf den Drehteller 2 aufliegender Substrate gemessen werden kann. Die Oberflächentemperatur kann durch eine Variation der Höhe des Gaspolsters 3 variiert werden.

Unterhalb des Suszeptors 1 befindet sich eine Heizung 27, bei der es sich um eine Strahlungsheizung oder um eine RF-Heizung handeln kann. Mit dieser Heizung wird zunächst die Unterseite des Suszeptors 1 aufgeheizt. Die Wärme wird im Wesentlichen über Wärmeleitung bis zum Gaspolster transportiert und dann ebenfalls über Wärmeleitung bzw. Wärmestrahlung durch den vom Gaspolster 3 gebildeten Spalt hindurch zum Drehteller 2 transportiert. Durch die Höhe des Gaspolsters 3 kann der Wärmetransport beeinflusst werden.

Die Höhe des Gaspolsters 3 wird durch die Menge des Gasstroms bestimmt, welcher durch die jeweilige Zuleitung 26 strömt. Dieser Gasstrom wird mit einem Ventil 5 eingestellt. Die Stellung des Ventils 5 erfolgt abhängig von der mit dem Temperatursensor 4 gemessenen Temperatur. Bei dem Ventil 5 handelt es sich bevorzugt um ein seine Stellung auch stromlos haltendes Ventil. Es kann über nicht dargestellte Schleifkontakte oder telemetrisch über Funk seine Stellwerte erhalten. Das Ventil 5 wird jeweils dann verstellt, wenn mit dem Temperatursensor 4 die Oberflächentemperatur des zugeordneten Drehtellers 2 gemessen worden ist und eine Änderung der Temperatur erforderlich ist.

Der Suszeptor 1 ruht auf einem Träger 6. Der Träger 6 besitzt eine Hohlwelle 31, auf deren Stirnrand der Suszeptor 1 aufliegt. Innerhalb der Hohlwelle 31 verlaufen in gleichmäßiger Umfangsverteilung um das Zentrum Z angeordnete Gaszuleitungen 12, welche das das Gaspolster 3 ausbildende Trägergas, bei dem es sich um Stickstoff oder Wasserstoff handeln kann, von einem Ventil 5 zu Kanälen 26 im Suszeptor 1 leiten.

Die Hohlwelle 31 ist in einem fest mit dem Reaktorgehäuse 11 verbundenen Lagergehäuse 20 gelagert. Hierzu besitzt das Lagergehäuse 20 eine Lagerhöhlung, in welcher zwischen zwei Drehlagern 29,30 eine Dichtung 28 angeordnet ist.

Aus der Unterseite des Lagergehäuses 20 ragt ein Abschnitt der Hohlwelle 31, welcher neben einem Abtriebsrad 21 auch eine Vielzahl von Ventilen 5 trägt. Die Ventile 5 sind in gleichmäßiger Umfangsverteilung um das Zentrum Z, also sternförmig, angeordnet. Parallel zu den in Achsrichtung sich erstreckenden Gasleitungen 12 sind in der Hohlwelle 31 individuelle Zuleitungen 9 angeordnet, die das Gas von einem Gasverteilvolumen 8 zum Ventil 5 leiten.

Innerhalb der Hohlwelle 31 befindet sich ein Kern 13, der drehfest mit dem Reaktorgehäuse 11 verbunden ist und der einen Antriebsmotor 23 trägt, der ein Antriebsrad 22 aufweist, mit dem über einen nicht dargestellten Antriebsriemen das Abtriebsrad 21 gedreht werden kann. Die Hohlwelle 31 und die von ihr getragenen Ventile 5 drehen sich dann um die Drehachse Z und nehmen den Suszeptor 1 mit, so dass sich der Suszeptor 1 relativ gegenüber dem gehäusefesten Gaseinlassorgan 24 drehen kann.

Ein Abschnitt 14 der Außenwandung des Kernes 13 bildet eine Innenwandung der ringförmig den Kern umgebenden Kammer, die das Gasverteilvolumen 8 ausbildet. Die nach außen weisende Wandung 15 der Ringkammer 8 wird von der Innenwandung der Hohlwelle 31 ausgebildet. Die beiden ringförmigen oberen und unteren Wände des Gasverteilvolumens 8 werden jeweils von Dichtelementen 16,17 ausgebildet, die oberhalb eines Lagers 18 bzw. unterhalb eines Lagers 19 angeordnet sind.

Der Kern 13 besitzt die gemeinsame Zuleitung 7, die an der Stirnseite des Kernes 13 einen Anschluss an eine Gasleitung besitzt. Die Zuleitung 7 verläuft zunächst parallel zur Zentrumsachse Z. Ein Radialfortsatz der Zuleitung 7 mündet unter Ausbildung einer Öffnung der Kammerinnenwand 14 in das Gasverteilvolumen 8. In der der Kammerinnenwandung 14 gegenüberliegenden Kammeraußenwandung 15 befinden sich die Öffnungen der individuellen Zuleitungen 9, durch die das in die Kammer 8 eingeströmte Gas zu den Ventilen 5 geleitet wird. Die Zuleitungen 9 verlaufen zunächst in Radialrichtung und anschließend parallel zur Zentrumsachse Z.

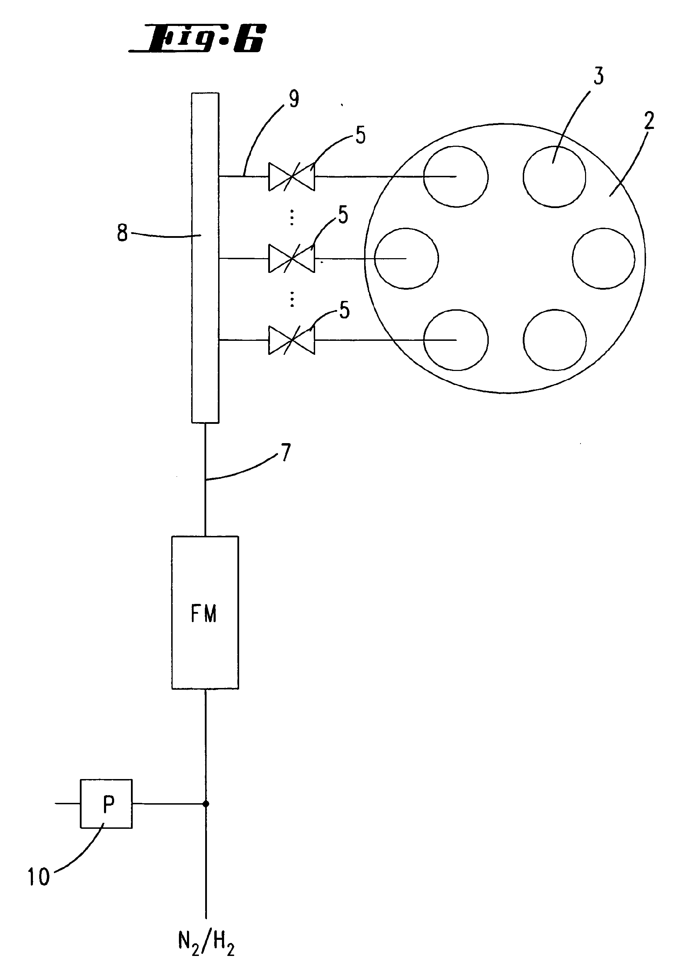

Der Fig. 6 ist zu entnehmen, dass der Druck in der gemeinsamen Zuleitung 7 mittels eines Druck-Controllers 10 konstant gehalten wird. In der gemeinsamen Gaszuleitung 7 ist darüber hinaus ein optionales Flussmessgerät FM vorgesehen. Als Gas zur Erzeugung der Gaspolster 3 kann neben dem erwähnten Stickstoff und Wasserstoff auch ein Edelgas oder ein anderweitiges brauchbares Gas verwenden werden.

Die mit dem Suszeptor 1 mitdrehenden Ventile 5 können permanent bestromt werden. Hierzu ist eine Stromzuführung über nicht dargestellte Gleitschleifkontakte zwischen beispielsweise dem Kern 13 und der Hohlwelle 31 bzw. dem Gehäuse 20 und der Hohlwelle 31 vorgesehen. Die Ventile 5 können aber auch induktiv mit Energie versorgt werden. Darüber hinaus können die Ventile auch nur periodisch mit elektrischer Energie versorgt werden.

## Patentansprüche

1. CVD-Reaktor mit einer Vielzahl auf einem drehangetriebenen Suszeptor (1) auf dynamischen Gaspolstern (3) getragenen Drehtellern (2), wobei jedes Gaspolster (3) von einem individuell gesteuerten Gasstrom gebildet wird und jeder Gasstrom abhängig von einer von einem Temperaturmessorgan (4) gemessenen Oberflächentemperatur von einem individuellen Stellglied (5) variierbar ist, mit einem den Suszeptor (1) tragenden, mit dem Suszeptor (1) drehenden Träger (6), **gekennzeichnet, durch** eine in den Träger (6) mündende gemeinsame Gaszuleitung (7), mit der die am Träger (6) angeordneten Stellglieder (5) mit dem den Gasstrom bildenden Gas versorgt werden.

2. CVD-Reaktor nach Anspruch 1, **dadurch gekennzeichnet, dass** die gemeinsame Gaszuleitung (7) in ein Gasverteilvolumen (8) mündet; von welchem individuelle Leitungen (9) zu jedem Stellglied (5) abzweigen.

3. CVD-Reaktor nach einem der Ansprüche 1 oder 2, **dadurch gekennzeichnet, dass** die Stellglieder Ventile (5) sind, die telemetrisch oder über Schleifkontakte von außen betätigbar sind.

4. CVD-Reaktor nach Anspruch 3, **dadurch gekennzeichnet, dass** die Ventile (5) stromlos ihre Stellung halten.

5. CVD-Reaktor nach einem der Ansprüche 1 bis 4, **gekennzeichnet durch** einen der gemeinsamen Zuleitung (7) zugeordneten Druck-Controller (10) zum Konstanthalten des Gasdrucks in der gemeinsamen Zuleitung (7).

6. CVD-Reaktor nach einem der Ansprüche 1 bis 5, **gekennzeichnet durch** ein Temperaturmessorgan (4), welches derart angeordnet ist, dass die Oberflächentemperaturen mehrerer, im Wesentlichen ringförmig um das Drehzentrum (Z) des Suszeptors (1) angeordneter Drehteller (2) nacheinander gemessen werden können, um die Gasströme zu den zugehörigen Gaspolstern (3) entsprechend nacheinander zu variieren.

7. CVD-Reaktor nach einem der Ansprüche 1 bis 6, **dadurch gekennzeichnet, dass** der Träger (6) im Wesentlichen im Inneren eines Reaktorgehäuses (11) angeordnet ist.

8. CVD-Reaktor nach einem der Ansprüche 3 bis 7, **dadurch gekennzeichnet, dass** der Abschnitt des Trägers (6), welcher die Ventile (5) trägt, außerhalb des Reaktorgehäuses (11) angeordnet ist.

9. CVD-Reaktor nach einem der Ansprüche 1 bis 8, **gekennzeichnet durch** eine bezogen auf die Drehachse (Z) des Trägers (6) sternförmige Anordnung der Zuleitungen (9,12) und der Stellglieder (5).

10. CVD-Reaktor nach einem der Ansprüche 1 bis 9, **dadurch gekennzeichnet, dass** der Träger (6) eine Hohlwelle (31) umfasst, die in sich einen gehäusefesten, die gemeinsame Zuleitung (7) ausbildenden Kern (13) aufnimmt.

11. CVD-Reaktor nach einem der Ansprüche 1 bis 10, **dadurch gekennzeichnet, dass** die Hohlwelle (31) in einer Lagerhöhlung eines fest mit dem Reaktorgehäuse (11) verbundenen Lagergehäuse (20) drehgelagert ist.

12. CVD-Reaktor nach einem der Ansprüche 1 bis 11, **dadurch gekennzeichnet, dass** das Gasverteilvolumen (8) eine zwischen Kern (13) und Hohlwelle (31) angeordnete Ringkammer ist.

## Claims

1. CVD reactor with a multiplicity of rotary tables (2) carried on dynamic gas cushions (3) on a rotationally driven susceptor (1), each gas cushion (3) being formed by an individually controlled gas flow and each gas flow being variable by means of an individual control element (5) according to a surface temperature measured by a temperature measuring device (4), and with a carrier (6) carrying the susceptor (1) and rotating with the susceptor (1), **characterized by** a common gas supply line (7), which opens out into the carrier (6) and with which the control elements (5) disposed on the carrier (6) are supplied with the gas forming the gas flow.

2. CVD reactor according to Claim 1, **characterized in that** the common gas supply line (7) opens out into a gas distribution volume (8), from which individual lines (9) branch off to each control element (5).

3. CVD reactor according to either of Claims 1 and 2, **characterized in that** the control elements are valves (5), which can be actuated from the outside telemetrically or by means of sliding contacts.

4. CVD reactor according to Claim 3, **characterized in that** the valves (5) maintain their position without power.

5. CVD reactor according to any of Claims 1 to 4, **characterized by** a pressure controller (10), associated with the common supply line (7), for keeping the gas pressure in the common supply line (7) constant.

6. CVD reactor according to any of Claims 1 to 5, **characterized by** a temperature measuring element (4), which is disposed in such a way that the surface temperatures of a number of rotary tables (2), disposed substantially in the form of a ring around the center of rotation (Z) of the susceptor (1), can be measured one after the other in order to vary the gas flows to the associated gas cushions (3) correspondingly one after the other.

7. CVD reactor according to any of Claims 1 to 6, **characterized in that** the carrier (6) is disposed substantially in the interior of a reactor housing (11).

8. CVD reactor according to any of Claims 3 to 7, **characterized in that** the portion of the carrier (6) that carries the valves (5) is disposed outside the reactor housing (11).

9. CVD reactor according to any of Claims 1 to 8, **characterized by** the supply lines (9, 12) and the control elements (5) being disposed in a star pattern with respect to the axis of rotation (Z) of the carrier (6).

10. CVD reactor according to any of Claims 1 to 9, **characterized in that** the carrier (6) comprises a hollow shaft (31), which accommodates a core (13) that is fixed to the housing and provides the common supply line (7).

11. CVD reactor according to any of Claims 1 to 10, **characterized in that** the hollow shaft (31) is rotationally mounted in a bearing cavity of a bearing housing (20) fixedly connected to the reactor housing (11).

12. CVD reactor according to any of Claims 1 to 11, **characterized in that** the gas distribution volume (8) is an annular chamber disposed between the core (13) and the hollow shaft (31).

## Revendications

1. Réacteur CVD comportant un grand nombre de plateaux rotatifs (2) supportés par des coussins de gaz dynamiques (3) sur un suscepteur (1) entraîné en rotation, chaque coussin de gaz (3) étant formé par un flux de gaz commandé individuellement et chaque flux de gaz pouvant être modifié par un élément de commande individuel (5) en fonction d'une température de surface mesurée par un organe de mesure de température (4), et un support (6) supportant le suscepteur (1) et tournant avec le suscepteur (1), **caractérisé par** une conduite d'amenée de gaz commune (7) débouchant dans le support (6) et alimentant les éléments de commande (5), disposés au niveau du support (6), en gaz formant le flux de gaz.

2. Réacteur CVD selon la revendication 1, **caractérisé en ce que** la conduite d'amenée de gaz commune (7) débouche dans un volume de distribution de gaz (8) d'où partent des conduites individuelles (9) en direction de chaque élément de commande (5).

3. Réacteur CVD selon l'une des revendications 1 ou 2, **caractérisé en ce que** les éléments de commande sont des clapets (5) qui peuvent être actionnés de l'extérieur par télémétrie ou par des contacts frottants.

4. Réacteur CVD selon la revendication 3, **caractérisé en ce que** les clapets (5) conservent leur position hors tension.

5. Réacteur CVD selon l'une des revendications 1 à 4, **caractérisé par** un contrôleur de pression (10) affecté à la conduite d'amenée commune (7) et destiné à maintenir constante la pression du gaz dans la conduite d'amenée commune (7).

6. Réacteur CVD selon l'une des revendications 1 à 5, **caractérisé par** un organe de mesure de température (4) qui est disposé de façon à pouvoir mesurer successivement les températures de surface de plusieurs plateaux rotatifs (2) disposés sensiblement annulairement autour du centre de rotation (Z) du suscepteur (1) afin de modifier successivement de façon appropriée les flux de gaz allant aux coussins de gaz associés (3).

7. Réacteur CVD selon l'une des revendications 1 à 6, **caractérisé en ce que** le support (6) est disposé sensiblement à l'intérieur d'un boîtier de réacteur.

8. Réacteur CVD selon l'une des revendications 3 à 7, **caractérisé en ce que** la portion du support (6), qui supporte les clapets (5), est disposée à l'extérieur du boîtier de réacteur (11).

9. Réacteur CVD selon l'une des revendications 1 à 8, **caractérisé en ce que** les conduites d'amenée (9, 12) et les éléments de commande (5) sont disposés en étoile par rapport à l'axe de rotation (Z) du support (6).

10. Réacteur CVD selon l'une des revendications 1 à 9, **caractérisé en ce que** le support (6) comporte un arbre creux (31) dans lequel est logé un noyau (13) fixé au boîtier et formant la conduite d'amenée commune (7).

11. Réacteur CVD selon l'une des revendications 1 à 10, **caractérisé en ce que** l'arbre creux (31) est monté à rotation dans un creux formant palier d'un boîtier de palier (20) relié fixement au boîtier de réacteur (11).

12. Réacteur CVD selon l'une ou plusieurs des revendications 1 à 11, **caractérisé en ce que** le volume de distribution de gaz (8) est une chambre annulaire ménagée entre le noyau (13) et l'arbre creux (31).
